# EUROPÄISCHE PATENTSCHRIFT

(11) **EP 3 326 211 B1**
(45) Veröffentlichungstag und Bekanntmachung des Hinweises auf die Patenterteilung: **28.08.2019**
(21) Anmeldenummer: 16750652.6
(22) Anmeldetag: 25.07.2016
(51) Int. Cl.: H01L 31/0224, H01L 31/0747

(54) **VERFAHREN ZUR HERSTELLUNG EINSEITIG ANGEORDNETER STRUKTURIERTER KONTAKTE IN EINER SCHICHTANORDNUNG FÜR EIN PHOTOVOLTAISCHES BAUELEMENT**
METHOD FOR PRODUCING STRUCTURED CONTACTS, WHICH ARE ARRANGED ON ONE SIDE, IN A LAYER ARRANGEMENT FOR A PHOTOVOLTAIC COMPONENT
PROCÉDÉ DE FABRICATION D'UN CONTACT STRUCTURÉ DISPOSÉ D'UN SEUL CÔTÉ DANS UN AGENCEMENT DE COUCHES DESTINÉ À UN COMPOSANT PHOTOVOLTAÏQUE

(30) Priorität: 23.07.2015 DE 102015112046
(43) Veröffentlichungstag der Anmeldung: 30.05.2018
(73) Patentinhaber: Helmholtz-Zentrum Berlin für Materialien und Energie GmbH, 14109 Berlin (DE)
(72) Erfinder: RING, Sven, 10247 Berlin (DE); KIRNER, Simon, 12047 Berlin (DE); SCHLATMANN, Rutger, 14195 Berlin (DE)
(86) Internationale Anmeldenummer: PCT/EP2016/067675
(87) Internationale Veröffentlichungsnummer: WO 2017/013268

(56) Entgegenhaltungen:
- WO-A1-2005/024927
- WO-A1-2015/060012
- DE-A1-102007 051 725
- DE-A1-102009 057 881
- JP-A- 2013 197 555
- US-A1- 2014 373 919
- T DESRUES ET AL: "SILICON HETEROJUNCTION FOR ADVANCED REAR CONTACT CELLS: MAIN RESULTS OF THE SHARCC PROJECT", PROCEEDINGS OF THE 28TH EUROPEAN PHOTOVOLTAIC SOLAR ENERGY CONFERENCE AND EXHIBITION, 30. September 2013 (2013-09-30), Seiten 1135-1138, XP055316722, in der Anmeldung erwähnt
- S. DE VECCHI ET AL: "Point Contact Technology for Silicon Heterojunction Solar Cells", ENERGY PROCEDIA, Bd. 27, 1. Januar 2012 (2012-01-01), Seiten 549-554, XP055316290, NL ISSN: 1876-6102, DOI: 10.1016/j.egypro.2012.07.108 in der Anmeldung erwähnt
- KRISTER MANGERSNES ET AL: "Damage free laser ablation of SiO sub 2| for local contact opening on silicon solar cells using an a-Si:H buffer layer", JOURNAL OF APPLIED PHYSICS, Bd. 107, Nr. 4, 1. Januar 2010 (2010-01-01), Seite 043518, XP055002450, ISSN: 0021-8979, DOI: 10.1063/1.3309382 in der Anmeldung erwähnt
- FELIX HAASE ET AL: "Layer selective laser ablation for local contacts to thin emitters", ENERGY PROCEDIA, Bd. 8, 17. April 2011 (2011-04-17), - 20. April 2011 (2011-04-20), Seiten 577-580, XP028263127, ISSN: 1876-6102, DOI: 10.1016/J.EGYPRO.2011.06.185 [gefunden am 2011-08-12] in der Anmeldung erwähnt

## Beschreibung

Die Erfindung betrifft ein Verfahren zur Herstellung einseitig angeordneter strukturierter Kontakte in einer Schichtanordnung für ein photovoltaisches Bauelement, das mindestens ein Substrat, eine erste dotierte Halbleiterschicht eines Leitfähigkeitstyps und eine zweite dotierte Halbleiterschicht mit entgegengesetztem Leitfähigkeitstyp aufweist. Das Verfahren weist mindestens die folgenden Verfahrensschritte auf: Aufbringen einer Maskierungsschichtanordnung mit mindestens einer Maskierungsschicht auf der auf dem Substrat angeordneten ersten dotierten Halbleiterschicht, Erzeugen von Strukturen für Kontaktöffnungen in der Maskierungsschichtanordnung, anschließendes Ätzen der strukturierten Maskierungsschichtanordnung, danach ganzflächiges konformes Aufbringen der zweiten dotierten Halbleiterschicht entgegengesetzten Leitfähigkeitstyps und folgend mindestens ein teilweises Entfernen der noch verbliebenen Maskierungsschichtanordnung und der zweiten dotierten Halbleiterschicht zum Freilegen der strukturierten ersten dotierten Halbleiterschicht sowie abschließendes Einbringen von Kontaktmaterial in die Kontaktöffnungen und auf die freigelegte erste dotierte Halbleiterschicht.

Speziell strukturierte Kontakte werden beispielsweise für Solarzellenkonzepte benötigt, die auf a-Si/c-Si(amorphes Silizium/kristallines Silizium)-Heteroübergängen beruhen und beide Kontaktsysteme auf der Rückseite der Solarzelle aufweisen. Die bisher meistens im Labormaßstab für die Ausbildung rückseitiger Kontaktsysteme angewendete Standardphotolithographie ist für einen Einsatz im Produktionsprozess zu teuer.

Dem Stand der Technik nach ist zur Strukturierung und/oder Ausbildung von Kontakten die Verwendung von Lasern bzw. das nasschemische Ätzen bekannt.

In den Proceedings zur 28^{th} PVSEC, 2013, 1135-1138 wird das Laserfeuem zur Strukturierung/Ausbildung von Absorberkontakten beschrieben.

Bei dem in DE 10 2007 051 725 A1 beschriebenen Verfahren zur Kontaktierung von Solarzellen wird eine Maskierungsschicht zur Ausbildung von schmalen Strukturen mittels Laserstrahlung geöffnet. Wird dabei die Substratoberfläche beschädigt, erhöht sich dort die Rekombination erzeugter Ladungsträger. Um derartige Schäden zu entfemen, wird die Oberfläche nasschemisch oder im Plasma geätzt.

Auch in DE 10 2009 057 881 A1 werden mittels Laserstrahlung Strukturen erzeugt. Hierbei ist eine Laserstrahlung absorbierende Absorberschicht auf eine für Laserstrahlung transparente Schicht aufgebracht. Mittels Laserstrahlung werden lokal Bereiche in der Absorberschicht entfernt, anschließend werden die nun frei liegenden Bereiche der transparenten Schicht mittels eines Ätzschritts entfernt.

In WO 2005/024927 A1 ist beschrieben, dass eine organische Isolierschicht u.a. auch mittels Laserablation entfernt wird, bevor Löcher bis in die Silizium-Absorberschicht geätzt werden. Ebenso ist daraus die Verwendung von fotografischen Techniken für die Erzeugung von Strukturen bekannt, bei denen aber kein Laser eingesetzt wird.

Bei dem in Energy Procedia 27 (2012) 549-554 beschriebenen Verfahren zur Herstellung einer punktkontaktierten Silizium-Solarzelle mit Heteroübergang wird zunächst ein Passivierungsschichtstapel mittels PECVD aufgebracht, der mit einer Siebdruckmaske abgedeckt und anschließend nasschemisch geätzt wird.

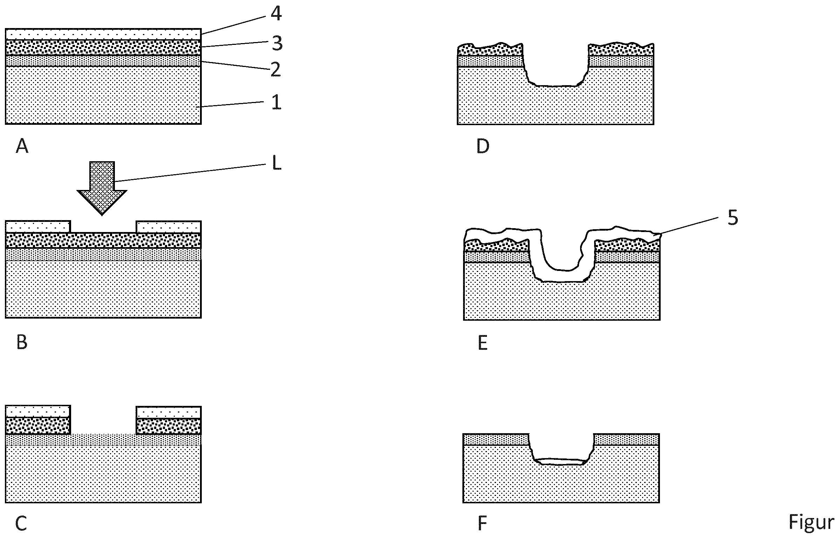

In JP 2013-197555 A ist ein Verfahren zur Herstellung einer Solarzelle entsprechend der dortigen Fig. 13 beschrieben. Dabei werden die sowohl für die Schichtanordnung einer solchen Solarzelle nicht benötigten Schichten bzw. Regionen hiervon als auch die eine Maskierungsschicht mittels isotropem chemischen Ätzen in einer alkalischen Lösung entfernt. Dabei wird eine einfache Maskierungsschicht aus Siliziumnitrid oder Siliziumoxid verwendet. Insbesondere wird keine Vorkehrung getroffen, dass die einfache Maskierungsschicht nach dem Ätzen in alkalischem Ätzmittel eine Aufrauung aufweist, und somit der nach Deposition einer weiteren Halbleiterschicht folgende Lift-Off-Schritt in kurzer Zeit erfolgen kann. Des Weiteren wird eine starke Unterätzung der Maskierungsschicht beschrieben, was lange Ätzzeiten erfordert und somit eine Belastung für die bei niederen Prozesstemperaturen abgeschiedene Maskierungsschicht bedeutet, was wiederum zur Bildung von Löchern in der Maskierungsschicht und damit zu Kurzschlüssen in der Solarzelle führen kann.

Der Stand der Technik, von dem die Erfindung ausgeht, ist in
US 2014/0373919 A1 beschrieben. Dort wird ein Verfahren zur Herstellung einer Photovoltaik-Zelle vorgestellt, das auch ein Verfahren zur Strukturierung verschiedener Schichten mit dem Ziel der Ausbildung von Kontakten auf der Rückseite der Photovoltaik-Zelle beinhaltet. Dieses Verfahren zur Ausbildung strukturierter Kontakte weist die folgenden Verfahrensschritte auf: Aufbringen einer amorphen Schicht mit einem ersten Leitfähigkeitstyp auf ein Substrat, Bedecken dieser amorphen Schicht mit einer elektrisch isolierenden Schicht, die als Maske in den Folgeschritten eingesetzt wird, anschließendes Ätzen der elektrisch isolierenden Schicht und der amorphen Schicht mit einem ersten Leitfähigkeitstyp, was mittels Laserbestrahlung und/oder nasschemischem Ätzen erfolgen kann. Damit wird eine erste Strukturierung realisiert. Danach wird eine zweite amorphe Schicht mit einem zweiten Leitfähigkeitstyp ganzflächig aufgebracht, die das Substrat mit dem erzeugten Muster aus erster amorpher Schicht und elektrisch isolierender Schicht bedeckt. Ein folgender Ätzschritt - ausgeführt wiederum mittels Laserbestrahlung und/oder nasschemischem Ätzen der zweiten amorphen Schicht und der elektrisch isolierenden Schicht - liefert dann die gewünschte Strukturierung in der zweiten amorphen Schicht für die Ausbildung der Kontaktöffnungen auf der Rückseite einer Photovoltaik-Zelle. Bei diesem zweiten Strukturierungsschritt mittels Laser wird ein Überlapp der gegensätzlich dotierten Schichten in Kauf genommen, um die komplette Fläche vollständig mit einer Passivierung zu versehen, was aus Gründen der Erhöhung der Lebensdauer der Minoritätsladungsträger immer bei derartigen Bauelementen angestrebt wird - Die elektrisch isolierende Schicht kann aus zwei Teilschichten bestehen, von denen die erste eine absorbierende Schicht ist, die beispielsweise reich an Silizium ist, sowie eine zweite als Schutzschicht ausgebildete Schicht, die beispielsweise arm an Silizium ist. Es wird ausgeführt, dass mittels Laserstrahlung die absorbierende Schicht in der gewünschten Struktur geöffnet wird, wobei keine Zerstörung der zweiten amorphen Schicht wegen der Schutzschicht auftritt. Die Schutzschicht wird anschließend mittels nasschemischem Ätzen entfernt. Zwar konnten mit dem beschriebenen Verfahren die industriellen Verfahrensschritte (im Vergleich zu Photolithographie, zu metallischen Masken oder zum Siebdruck) vereinfacht werden, jedoch erhöht sich die Prozessdauer durch die Notwendigkeit zweier Strukturierungsprozesse, da die gesamte Fläche mit dem Laser behandelt wird. Außerdem ist für den zweiten Strukturierungsprozess eine Ausrichtung zur ersten erzeugten Struktur erforderlich, was die Prozesssicherheit verringert. Des Weiteren treten beim zweiten Strukturierungsschritt in der Überlappzone benachbarter Laserpulse Schädigungen des Substrats auf, da dort die Schutzschicht bereits im jeweils vorherigen Laserpuls abgetragen wurde.

In JOURNAL OF APPLIED PHYSICS 107, 043518 (2010) wird ein Verfahren zur zerstörungsfreien Laserablation von SiO₂ für die Bildung von Kontaktöffnungen beschrieben, bei dem eine a-Si-Pufferschicht zwischen einem kristallinen SiliziumSubstrat und einer dielektrischen SiO₂-Schicht angeordnet ist. Diese a-Si-Pufferschicht hat einen größeren optischen Absorptionskoeffizienten, ihr thermischer Diffusionskoeffizient ist mehr als zwei Größenordnungen kleiner als der des kristallinen Silizium-Substrats und deshalb für die Laseranwendung geeignet, um so das kristalline Substrat zu schützen.

Auch bei dem in Energy Procedia 8 (2011) 577-580 beschriebenen Verfahren werden mittels Laserablation Kontaktstrukturen in einer a-SiN-Schicht erzeugt. In dem c-Si-Substrat werden keine Schädigungen der Kristallstruktur hervorgerufen, da zwischen der a-SiN-Schicht und dem c-Si-Substrat ebenfalls eine a-Si-Schicht angeordnet ist.

WO 2015/060012 A1 offenbart ein Verfahren zur Herstellung einseitig angeordneter strukturierter Kontakte in einer Schichtanordnung für ein photovoltaisches Bauelement, das ein Substrat, eine erste dotierte Halbleiterschicht eines Leitfähigkeitstyps und eine zweite dotierte Halbleiterschicht mit entgegengesetztem Leitfähigkeitstyp aufweist.

Aufgabe der Erfindung ist es, ein weiteres gattungsgemäßes Verfahren gemäß Oberbegriff des Anspruchs 1 anzugeben, das eine Zeitersparnis durch Einsatz nur eines lateralen Strukturierungsschrittes und ohne aufwändige Ausrichtung der strukturierten Schichten zueinander sowie einen - im Vergleich zum Stand der Technik - schnelleren Lift-Off-Schritt bei gleichzeitig höherer Prozesssicherheit ermöglicht.

Die erfindungsgemäße Lösung für diese Aufgabe ist den beiden nebengeordneten Ansprüchen 1 und 2 zu entnehmen, vorteilhafte Weiterbildungen der Erfindung werden in den zugehörigen Unteransprüchen aufgezeigt und im Folgenden im Zusammenhang mit der Erfindung näher erläutert.

Die Aufgabe wird durch ein Verfahren der eingangs genannten Art dadurch gelöst, dass in einer ersten Variante der Erfindung als erste dotierte Halbleiterschicht eines Leitfähigkeitstyps und/oder als zweite dotierte Halbleiterschicht mit entgegengesetztem Leitfähigkeitstyp eine dotierte Silizium-reiche Schicht verwendet wird, die nanokristallin oder amorph ist, und außerdem für die mindestens eine Maskierungsschicht eine Einzelschicht verwendet wird,_wobei die Einzelschicht aus SiOxN_{y} gebildet wird und einen Gradienten im Siliziumgehalt von gering in der Nähe des Substrats und zunehmend in Richtung der aufzubringenden zweiten dotierten Halbleiterschicht aufweist. Das Ätzen der strukturierten Einzelschicht wird in mindestens einem Ätzschritt in einer Silizium-ätzenden Lösung mindestens zur Entfernung der ersten dotierten Silizium-reichen Schicht in den Kontaktöffnungen durchgeführt und gleichzeitig dabei die verbliebene frei liegende Oberfläche der Einzelschicht aufgeraut. Das mindestens teilweise Entfernen der noch verbliebenen Einzelschicht und der auf ihrer rauen Oberfläche angeordneten zweiten dotierten Silizium-reichen Schicht zum Freilegen der strukturierten ersten Silizium-reichen Schicht wird mittels Lift-Off-Prozess in einer HF-haltigen Lösung ausgeführt.

Die zweite Variante der Erfindung für ein Verfahren der eingangs genannten Art sieht vor, dass als erste dotierte Halbleiterschicht eines Leitfähigkeitstyps und/oder als zweite dotierte Halbleiterschicht mit entgegengesetztem Leitfähigkeitstyp eine dotierte Silizium-reiche Schicht verwendet wird, die nanokristallin oder amorph ist. Für die Maskierungsschichtanordnung werden zwei Maskierungsschichten mit Materialien unterschiedlicher selektiver Ätzbarkeit aufgebracht, wobei die dem Substrat am nächsten angeordnete Maskierungsschicht eine Silizium-arme Schicht mit größerer Ätzbarkeit in HF-haltigem Ätzmittel als die zweite Maskierungsschicht ist, die Silizium-reich ausgebildet ist und in Si-ätzendem Ätzmittel ätzbar ist. Das Ätzen der strukturierten Maskierungsschichtanordnung wird in mindestens einem Ätzschritt in einer Silizium-ätzenden Lösung mindestens zur Entfernung der ersten dotierten Silizium-reichen Schicht in den Kontaktöffnungen und zur Entfernung der Si- reichen Maskierungsschicht in den unstrukturierten Bereichen der Maskierungsschichtanordnung durchgeführt, wobei gleichzeitig die verbliebene frei liegende Oberfläche der Silizium-armen Maskierungsschicht aufgeraut wird. Diese aufgeraute Oberfläche der Silizium-armen Maskierungsschicht ist notwendig für den folgenden Lift-Off-Prozess in einer verdünnten HF-Lösung, durch den mindestens teilweise die noch verbliebene Silizium-arme Maskierungsschicht und die auf ihrer rauen Oberfläche angeordnete zweite dotierte Silizium-reiche Schicht zum Freilegen der strukturierten ersten dotierten Silizium-reichen Schicht entfernt wird.

Überraschenderweise hat sich nämlich herausgestellt, dass bei der Durchführung eines Lift-Off-Schrittes in der Technologie für photovoltaische Bauelemente, die Verfahrensschritte mit Maskierungsschichten aufweisen, der Grenzregion bzw. Grenzfläche zwischen einer Silizium-armen und einer Silizium-reichen Schicht besondere Bedeutung zukommt. Der Silizium-Gradient in der Maskierungsschicht bzw. die benachbarte Anordnung Silizium-armer und Silizium-reicher Maskierungsschichten bedeuten nämlich auch eine Änderung in der Ätzbarkeit. Die Silizium-reiche Schicht ist damit auch in Silizium ätzender Lösung ätzbar. Die erwähnten Ätzschritte bewirken nämlich neben dem gezielten Abtragen der Silizium-reichen Maskierungsschichten und Slizium-reicher Oberflächenbereiche von Maskierungsschichten und funktionaler Schichten des photovoltaischen Bauelements auch ein - unerwartetes - prozessbedingtes starkes Aufrauen der zum Substrat am nächsten angeordneten Silizium-armen Maskierungsschicht oder Silizium-armen Bereiche der Maskierungsschicht. Durch diesen unerwarteten Effekt erfolgt nach der Deposition der zweiten dotierten Halbleiterschicht der Lift-Off-Schritt wesentlich schneller als im Vergleich zum Stand der Technik, bei dem keine prozesstechnische Vorkehrung zu einer besonderen Aufrauung der Maskierungsschicht erfolgt, und der Lift-Off-Schritt deshalb bis zu 100 Mal langsamer abläuft.

Das für die Maskierungsschichten verwendete Material ist kompatibel mit typischen Prozessen (z.B. PECVD), wie sie für die Abscheidung der zweiten dotierten Halbleiterschicht verwendet werden. Insbesondere werden keine organischen Schichten, wie z.B. Photoresist, verwendet.

Für beide Erfindungsvarianten hat es sich als vorteilhaft erwiesen, vor dem Ätzen der strukturierten einzelnen Maskierungsschicht bzw. vor dem Ätzen der strukturierten Maskierungsschichtanordnung einen weiteren Ätzschritt in HF-haltiger Lösung durchzuführen. Dieser dient der Entfernung der Reste der Silizium-armen Maskierungsschicht in den Kontaktöffnungen. Bei diesem Ätzschritt in HF-haltiger Lösung erfolgt noch kein Lift-off, da die Silizium-arme Maskierungsschicht noch nicht aufgeraut ist.

In Ausführungsformen zur zweiten Variante der Erfindung ist vorgesehen, dass als Silizium-arme Maskierungsschicht eine in einer verdünnten HF-Lösung ätzbare SiOₓN_{y}-Schicht, beispielsweise eine SiO₂-Schicht, verwendet wird. Es hat sich gezeigt, dass sowohl das ätzgesteuerte Aufrauen dieser Maskierungsschicht als auch ihre chemische Dichtheit als Schutz für die darunterliegende erste dotierte Silizium-reiche Schicht Voraussetzungen für den beschriebenen Lift-Off-Prozess sind. Dies kann besonders gut realisiert werden, wenn die SiOₓN_{y}-Schicht als Schichtfolge aufgebaut ist, wobei die die Schichtfolge abschließende Schicht - also die dem Ätzmittel zuerst ausgesetzte Schicht - am Silizium-reichsten ist, oder die SiOₓN_{y}-Schicht einen Gradienten im Siliziumgehalt aufweist, der zur Oberfäche dieser Schicht - also Richtung Ätzmittel - zunimmt. Ziel dieses Verfahrensschrittes ist es, auf der dem Ätzmittel zugewandten Oberfläche ein Silizium-reiches Material anzubieten. Dem Fachmann ist bekannt, dass nur sehr Silizium-reiche Schichten mit einem Brechungsindex > 3 eine große Ätzbarkeit in alkalischer Lösung aufweisen. Für Silizium-reiche Schichten können beispielsweise oxynitridische oder Siliziumnitrid-Schichten oder Siliziumkarbid-Schichten verwendet werden. Wie bereits erwähnt, schließt in dem erfindungsgemäßen Verfahren die Maskierungsschicht bzw. die Maskierungsschichtanordnung mit hohem Siliziumgehalt ab. Diese weist zu der Silizium-armen Schicht eine größere selektive Ätzbarkeit in einem Silizium-ätzenden Mittel auf und bewirkt damit eine erhöhte Rauigkeit an der Oberfläche der Silizium-armen Schicht. Diese Siliziumreiche Schicht -kann gleichzeitig als absorbierende Schicht für die Laserstrahlung dienen, wodurch weniger Laserenergie im Substrat absorbiert, und dadurch eine geringere Ätztiefe in das Substrat hinein erforderlich ist. Für diese Silizium-reiche zweite Maskierungsschicht kann eine amorphe oder nanokristalline Si-Schicht verwendet werden. Insbesondere die Verwendung einer p-dotierten a-Si-Schicht schützt die erste dotierte Halbleiterschicht eines Leitfähigkeitstyps auch in den Bereichen, in denen in der Silizium-armen Schicht durch fehlerhafte Abscheidung Löcher entstanden sind.

Die SiOₓN_{y}-Schicht in der Maskierungsschichtanordnung wird dabei mit einer Dicke zwischen 20 nm und 1.000 nm und die amorphe oder nanokristalline Silizium-reiche Schicht mit einer Dicke zwischen 10 nm und 200 nm aufgebracht.

Als Silizium-ätzende Lösung kann in dem erfindungsgemäßen Verfahren eine alkalische Lösung (wie z.B. KOH oder NaOH oder TMAH) oder beispielsweise eine Mischung aus HNO₃/HF/H₂O, die typisch ist für isotropes Ätzen von PolySilizium, verwendet werden.

In einer anderen Ausführungsform zur zweiten Variante der Erfindung wird auf der Maskierungsschichtanordnung vor dem Schritt der Strukturierung von Kontaktöffnungen eine weitere Silizium-arme und in verdünnter HF-Lösung ätzbare SiOₓN_{y}-Schicht aufgebracht. Bei dieser Anordnung aus drei Schichten können nun ebenfalls in zwei Ätzschritten die Kontaktlöcher erzeugt werden. Dabei wird in dem ersten Ätzschritt mit verdünnter HF-Lösung die bedeckende SiOₓN_{y}-Schicht vollständig und in den erzeugten Kontaktstrukturen die mindestens eine Maskierungsschicht bis zum Substrat entfernt. Im zweiten Ätzschritt wird außerhalb der Kontaktstrukturen die weitere Maskierungsschicht, die zu der SiOₓN_{y}-Schicht eine größere selektive Ätzbarkeit in einem Silizium-ätzenden Mittel aufweist, entfernt und die darunterliegende Maskierungsschicht aufgeraut. Um zusätzlich einen Perforierungseffekt der Silizium-reichen Schicht während des Ausbildens der Kontaktöffnungen zu erreichen, wird den beiden beschriebenen Ätzschritten - ein weiterer Ätzschritt - wiederum in einer Silizium-ätzenden Lösung - vorangestellt.

Die Strukturen für die Kontaktöffnungen in beiden Erfindungsvarianten können mittels Laserablation erzeugt werden, wobei ein ps- oder ns-Laser typischerweise bei den Wellenlängen 355 nm oder 532 nm, mit einer Pulsenergiedichte von 0,05 bis 1 Jcm⁻² und beispielsweise mit rundem oder eckigem Strahlquerschnitt und einem beispielsweise gaussförmigen oder trapezförmigen Intensitätsprofil verwendet wird, oder mittels nasschemischem Ätzen (beispielsweise mittels Inkjet-Strukturierung) erfolgen.

Auch bei den beiden erfindungsgemäßen Varianten zur Herstellung einseitig angeordneter strukturierter Kontakte in einer Schichtanordnung für ein photovoltaisches Bauelement ist es sinnvoll, vor dem Abscheiden der ersten dotierten amorphen Silizium-Schicht auf das Substrat und/oder vor dem Abscheiden der zweiten dotierten amorphen Silizium-Schicht jeweils eine intrinsische Wasserstoff-haltige amorphe Silizium-Schicht als Passivierungsschicht aufzubringen.

Die auf dem Substrat angeordneten beiden dotierten Silizium-reichen Schichten unterschiedlicher Leitfähigkeitstypen werden mit einer Dicke zwischen 8 nm und 30 nm aufgebracht, einschließlich der Dicke der jeweiligen intrinsischen Schicht. Dabei kann das Substrat einseitig oder auch beidseitig texturiert sein, beispielsweise mit pyramidenförmigen Strukturen.

Das erfindungsgemäße Verfahren ermöglicht eine Strukturierung von einseitig angeordneten Kontakten in photovoltaischen Bauelementen mit nur einem lateralen Laser-Strukturierungsschritt und eine selbstausrichtende Ausbildung der zweiten dotierten Silizium-reichen Schicht. Dabei ist es unerheblich, ob die Kontaktstruktur auf der Rück- oder Vorderseite des Bauelements ausgeführt werden soll. Bei der mit dem erfindungsgemäßen Verfahren in beiden Varianten hergestellten Anordnung sind die beiden dotierten Silizium-reichen Schichten unterschiedlichen Leitfähigkeitstyps "auf Stoß liegend" angeordnet, d.h. es wird eine vollflächige Passivierung der Oberfläche erreicht, außerdem tritt kein Überlapp auf, womit eine gute elektrische Isolierung benachbarter Bereiche dieser beiden Schichten gewährleistet ist.

Die Erfindung wird nun in zwei Ausführungsbeispielen anhand eines Prozessschemas mit den wichtigsten Schritten - s. Figur - erläutert.

Nach einer RCA-Reinigung und Eintauchen in eine 1%-ige HF-Lösung (HF-Dip zum Entfernen des natürlichen Oberflächenoxids) wird der monokristalline n-leitende Si-Wafer 1 beidseitig mit einer intrinsischen a-Si-Schicht der Dicke 5 nm. (nicht dargestellt) passiviert. Anschließend wird mittels PECVD auf der zukünftigen Rückseite eines photovoltaischen Bauelements eine Emitterschicht der Dicke 13 nm aus p-leitendem amorphen Silizium 2 aufgebracht. Danach erfolgt das Abscheiden der Maskierungsschichtanordnung aus zwei Schichten, d.h. einer SiO₂-Schicht 3 auf die Emitterschicht 2 und darauf einer amorphen Si-Schicht 4. Die SiO₂-Schicht 3 wird mittels PECVD (Plasma Enhanced Chemical Vapour Deposition) in einem Temperaturbereich von 150 °C bis 250 °C, einem Druck zwischen 0,1 und 2 Torr, mit CO₂ als Sauerstoffquelle, einem Leistungs-Druckverhältnis zwischen 50 und 5.000 W/Torr und einem Gasflussverhältnis SiH₄:H₂ zwischen 1:10 und 1:100, vorzugsweise 1:50, und einem Gasflussverhältnis SiH₄:CO₂ zwischen 1 : 10 und 1:100, vorzugsweise 1:25, aufgebracht. Die Dicke der abgeschiedenen SiO₂-Schicht 3 liegt dabei zwischen 20 nm und 1.000 nm, vorzugsweise bei 200 nm, und die der aSi-Schicht 4 zwischen 10 nm und 200 nm, vorzugsweise bei 20 nm. Diese Schichtfolge ist schematisch in Teilbild A dargestellt. Im folgenden Schritt werden die Strukturen für die Kontaktöffnungen mittels Laserablation in der oberen Maskierungsschicht 4 erzeugt. Hierfür wird ein 355 nm-Laser L (10 ps Pulsdauer mit trapezförmigem Querschnitt des Intensitätsprofils) mit Pulsenergiedichten von 0,1 Jcm⁻² verwendet. Das Ergebnis dieser Prozessschritte zeigt Teilbild B des Prozessschemas. Anschließend erfolgt ein Ätzen der strukturierten Maskierungsschichtanordnung, um die mittels Laser L in der absorbierenden aSi-Schicht 4 erzeugte Struktur in das monokristalline Si-Substrat zu übertragen, d.h. vollständiges Abtragen der SiO₂-Maskierungsschicht 3 in der durch Laserablation erzeugten Öffnung sowie der p-leitenden aSi-Emitterschicht 2 (und der nicht dargestellten intrinsischen a-Si-Schicht) und teilweises Abtragen (beispielsweise bis zu einer Tiefe von 100 nm) des Si-Wafers 1. Das Ätzen, bei dem die unterschiedliche Ätzselektivität der beiden Maskierungsschichten 3 und 4 ausgenutzt wird, wird in zwei Teilschritten durchgeführt, nämlich einem Ätzen in einer verdünnten HF-Lösung, beispielsweise in einer 2%-igen Lösung für 6 min (Ergebnis des Ätzschrittes ist in Teilbild C dargestellt), und einem anschließenden Ätzen in einer 50%-igen KOH-Lösung bei 70 °C für ca. 10 s. Neben dem Abtrag der beschriebenen Schichten sowie des Wegätzens des in den Kontaktöffnungen freigelegten Emitters 2 erfolgt auch ein Aufrauen (Anätzen) der verbliebenen SiO₂-Maskierungsschicht 3 (dargestellt in Teilbild D), was - wie bereits erwähnt - eine Voraussetzung für den im Weiteren folgenden Lift-Off-Schritt ist. Vor dem Lift-Off-Schritt wird bekanntermaßen die erzeugte Struktur zunächst mittels eines Reinigungsschrittes von Metallionen gereinigt und die dabei entstehende Oxidschicht mit einem HF-Dip entfernt. Anschließend wird mittels PECVD eine intrinsische a-Si-Schicht der Dicke 5 nm (nicht dargestellt) und eine n-leitende amorphe Si-Schicht 5 der Dicke 9 nm aufgebracht. Hierbei ist bereits eine Selbstausrichtung des abgeschiedenen n-leitenden Si-Materials in die geöffneten Strukturen für die Ausbildung der zweiten Kontaktbereiche gegeben (Teilbild E des Prozessschemas). Bei dem nun folgenden Lift-Off-Schritt, der in einer 5%-igen HF-Lösung für 2 min bis 3 min durchgeführt wird, wird der noch verbliebene Teil der SiO₂-Maskierungsschicht 3 vollständig und die auf ihrer rauen Oberfläche angeordneten n-leitenden amorphen Silizium-Schicht-Bereiche zum Freilegen der strukturierten ersten (p-leitenden) amorphen Silizium-Schicht 2 entfernt. Das Ergebnis ist schematisch im Teilbild F des Prozessschemas dargestellt. Abschließend werden die beiden Bereiche unterschiedlichen Leitfähigkeitstyps in den Kontaktöffnungen bzw. auf den freiliegenden Bereichen der ersten dotierten Halbleiterschicht mit entsprechendem Kontaktmaterial versehen. Die Kontakte der Absorberschicht können beispielsweise punktförmig, fingerförmig oder als Sammelschiene ausgebildet sein.

Eine weitere Verstärkung der aufrauenden Wirkung der Ätzschritte auf die mindestens eine Maskierungsschicht 3 kann durch eine "Doppelstack"-Maskierungsschichtanordnung bewirkt werden, die aus den bereits beschriebenen beiden Schichten, einer Silizium-armen dielektrischen SiO₂-Schicht und einer Silizium-reichen a-Si-Schicht besteht sowie einer weiteren als Schutzschicht ausgebildeten SiO₂-Schicht. Damit wird eine Maskierungsschichtanordnung mit der Schichtenfolge SiO₂/a-Si/SiO₂ gebildet. Die Ätzfolge dieser Maskierungsschichtanordnung wird um einen-Ätzschritt in einer Silizium-ätzenden Lösung als ersten Schritt erweitert. Die Behandlung in einer Silizium-ätzenden Lösung der nun obenliegenden SiO₂-Schutzschicht (Dicke 10 bis 100 nm) bewirkt gleichzeitig auch ein teilweises Durchdringen dieser Schicht, sodass die darunterliegende liegende (in KOH leicht ätzbare) Silizium-reiche Schicht perforiert wird. Ein nachfolgendes Ätzen in HF bewirkt nicht nur den Abtrag der obenliegenden SiO₂-Schicht und das Vertiefen der durch Laserablation erzeugten Öffnungen, sondern auch ein Ausbilden von Vertiefungen in der ersten Maskierungsschicht an den Stellen, an denen die siliziumreiche Schicht perforiert wurde. Nach dem anschließenden KOH-Ätzschritt tragen diese Vertiefungen zu einer erhöhten Rauigkeit bei. Der nun nachfolgende Lift-off-Schritt ist durch die besonders ausgeprägte Rauigkeit der geätzten Oberfläche stark begünstigt.

## Patentansprüche

1. Verfahren zur Herstellung einseitig angeordneter strukturierter Kontakte in einer Schichtanordnung für ein photovoltaisches Bauelement, das mindestens ein Substrat(1), eine erste dotierte Halbleiterschicht eines Leitfähigkeitstyps (2) und eine zweite dotierte Halbleiterschicht mit entgegengesetztem Leitfähigkeitstyp (5) aufweist, mindestens aufweisend die folgenden Verfahrensschritte:
- Aufbringen einer Maskierungsschichtanordnung (3, 4) mit mindestens einer Maskierungsschicht (3) auf der auf dem Substrat angeordneten ersten dotierten Halbleiterschicht,
- Erzeugen von Strukturen für Kontaktöffnungen in der ersten dotierten Halbleiterschicht in der Maskierungsschichtanordnung,
- anschließendes Ätzen der strukturierten Maskierungsschichtanordnung (3, 4) zur Erzeugung von Kontaktöffnungen in der ersten dotierten Halbleiterschicht (2),
- danach ganzflächiges konformes Aufbringen der zweiten dotierten Halbleiterschicht entgegengesetzten Leitfähigkeitstyps (5) und
- folgend mindestens ein teilweises Entfernen der noch verbliebenen Maskierungsschichtanordnung (3, 4) und der zweiten dotierten Halbleiterschicht (5) zum Freilegen der strukturierten ersten dotierten Halbleiterschicht (2) und
- abschließendes Einbringen von Kontaktmaterial in die Kontaktöffnungen und auf die freigelegte erste dotierte Halbleiterschicht, wobei als erste dotierte Halbleiterschicht eines Leitfähigkeitstyps (2) und als zweite dotierte Halbleiterschicht mit entgegengesetztem Leitfähigkeitstyp (5) eine dotierte Silizium-reiche Schicht verwendet wird, die nanokristallin oder amorph ist, **dadurch gekennzeichnet, dass**
- für die mindestens eine Maskierungsschicht (3) eine Einzelschicht verwendet wird, wobei die Einzelschicht aus SiOₓN_{y} gebildet wird und einen Gradienten im Siliziumgehalt von gering in der Nähe des Substrats (1) und zunehmend in Richtung der aufzubringenden zweiten dotierten Halbleiterschicht (5) aufweist,
- das Ätzen der strukturierten Maskierungsschichtanordnung mit einem Ätzen der strukturierten Einzelschicht (3) in mindestens einem Ätzschritt in einer Silizium-ätzenden Lösung mindestens zur Entfernung der ersten dotierten Silizium-reichen Schicht (2) in den Strukturen für Kontaktöffnungen durchgeführt und gleichzeitig die verbliebene frei liegende Oberfläche der Einzelschicht (3) aufgeraut wird,
- das mindestens teilweise Entfernen der noch verbliebenen Einzelschicht (3) und der auf ihrer rauen Oberfläche angeordneten zweiten dotierten Silizium-reichen Schicht (5) zum Freilegen der strukturierten ersten Silizium-reichen Schicht (2) mittels Lift-Off-Prozess in einer HF-haltigen Lösung ausgeführt wird.

2. Verfahren zur Herstellung einseitig angeordneter strukturierter Kontakte in einer Schichtanordnung für ein photovoltaisches Bauelement, das mindestens ein Substrat (1), eine erste dotierte Halbleiterschicht eines Leitfähigkeitstyps (2) und eine zweite dotierte Halbleiterschicht mit entgegengesetztem Leitfähigkeitstyp (5) aufweist, mindestens aufweisend die folgenden Verfahrensschritte:
- Aufbringen einer Maskierungsschichtanordnung (3, 4) mit mindestens einer Maskierungsschicht (3) auf der auf dem Substrat angeordneten ersten dotierten Halbleiterschicht (2),
- Erzeugen von Strukturen für Kontaktöffnungen in der ersten dotierten Halbleiterschicht (2) in der Maskierungsschichtanordnung (3, 4),
- anschließendes Ätzen der strukturierten Maskierungsschichtanordnung (3, 4) zur Erzeugung von Kontaktöffnungen in der ersten dotierten Halbleiterschicht (2),
- danach ganzflächiges konformes Aufbringen der zweiten dotierten Halbleiterschicht entgegengesetzten Leitfähigkeitstyps (5) und
- folgend mindestens ein teilweises Entfernen der noch verbliebenen Maskierungsschichtanordnung (3, 4) und der zweiten dotierten Halbleiterschicht (5) zum Freilegen der strukturierten ersten dotierten Halbleiterschicht (2) und
- abschließendes Einbringen von Kontaktmaterial in die Kontaktöffnungen und auf die freigelegte erste dotierte Halbleiterschicht, wobei als erste dotierte Halbleiterschicht eines Leitfähigkeitstyps (2) und als zweite dotierte Halbleiterschicht mit entgegengesetztem Leitfähigkeitstyp (5) eine dotierte Silizium-reiche Schicht verwendet wird, die nanokristallin oder amorph ist, **dadurch gekennzeichnet, dass**
- für die Maskierungsschichtanordnung (3, 4) zwei Maskierungsschichten (3, 4) mit Materialien unterschiedlicher selektiver Ätzbarkeit aufgebracht werden, wobei die dem Substrat am nächsten angeordnete Maskierungsschicht (3) eine Silizium-arme Schicht mit größerer Ätzbarkeit in HF-haltigem Ätzmittel als die zweite Maskierungsschicht (4) ist, die Silizium-reich ausgebildet ist und in Si-ätzendem Ätzmittel ätzbar ist,
- das Ätzen der strukturierten Maskierungsschichtanordnung (3, 4) in mindestens einem Ätzschritt in einer Silizium-ätzenden Lösung mindestens zur Entfernung der ersten dotierten Silizium-reichen Schicht (2) in den Strukturen für Kontaktöffnungen und zur Entfernung der Si- reichen Maskierungsschicht (4) in den unstrukturierten Bereichen der Maskierungsschichtanordnung (3, 4) durchgeführt wird, und wobei gleichzeitig die verbliebene frei liegende Oberfläche der Si-armen Maskierungsschicht (3) aufgeraut wird,
- das mindestens teilweise Entfernen der noch verbliebenen Silizium-armen Maskierungsschicht (3) und der auf ihrer rauen Oberfläche angeordneten zweiten dotierten Silizium-reichen Schicht (5) zum Freilegen der strukturierten ersten Silizium-reichen Schicht (2) mittels Lift-Off-Prozess in einer HF-haltigen Lösung ausgeführt wird.

3. Verfahren nach Anspruch 1,
**dadurch gekennzeichnet, dass**
vor dem Ätzen der strukturierten Maskierungsschicht (3) ein weiterer Ätzschritt in HF-haltiger Lösung durchgeführt wird.

4. Verfahren nach Anspruch 2,
**dadurch gekennzeichnet, dass**
vor dem Ätzen der strukturierten Maskierungsschichtanordnung (3, 4) ein weiterer Ätzschritt in HF-haltiger Lösung durchgeführt wird.

5. Verfahren nach Anspruch 2,
**dadurch gekennzeichnet, dass**
als Silizium-arme Maskierungsschicht (3) eine SiOₓN_{y}-Schicht verwendet wird.

6. Verfahren nach Anspruch 5,
**dadurch gekennzeichnet, dass**
die SiOₓN_{y}-Schicht (3) als Schichtfolge aufgebaut ist, wobei die die Schichtfolge abschließende Schicht am Silizium-reichsten ist.

7. Verfahren nach Anspruch 5,
**dadurch gekennzeichnet, dass**
die SiOₓN_{y}-Schicht (3) einen Gradienten im Siliziumgehalt aufweist, der zur Oberfläche dieser Schicht zunimmt.

8. Verfahren nach Anspruch 5,
**dadurch gekennzeichnet, dass**
als SiOₓN_{y}-Schicht (3) eine SiO₂-Schicht verwendet wird.

9. Verfahren nach Anspruch 2,
**dadurch gekennzeichnet, dass**
als zweite Silizium-reiche Maskierungsschicht (4) eine amorphe oder nanokristalline Si-Schicht verwendet wird.

10. Verfahren nach Anspruch 9,
**dadurch gekennzeichnet, dass**
als amorphe Si-Schicht (4) eine p-dotierte amorphe Si-Schicht verwendet wird.

11. Verfahren nach mindestens einem der vorangehenden Ansprüche 2 bis 10,
**dadurch gekennzeichnet, dass**
auf der Maskierungsschichtanordnung (3, 4) vor dem Schritt des Erzeugens von Strukturen für Kontaktöffnungen eine weitere SiOₓN_{y}-Schicht aufgebracht und vor den Ätzschritten ein weiterer nasschemische Ätzschritt in einer Silizium-ätzenden Lösung durchgeführt wird.

12. Verfahren nach Anspruch 1 oder 2,
**dadurch gekennzeichnet, dass**
das Erzeugen von Strukturen für Kontaktöffnungen mittels Laserablation erfolgt.

13. Verfahren nach Anspruch 1 oder 2,
**dadurch gekennzeichnet, dass**
das Erzeugen von Strukturen für Kontaktöffnungen mittels nasschemischem Ätzen erfolgt.

14. Verfahren nach Anspruch 1 oder 2,
**dadurch gekennzeichnet, dass** vor einem Abscheiden der ersten dotiertem Silizium-reichen Schicht (2) auf das Substrat und/oder vor einem Abscheiden der zweiten dotierten Silizium-reichen Schicht (5) jeweils eine intrinsische Wasserstoff-haltige amorphe Silizium-Schicht als Passivierungsschicht aufgebracht wird.

## Claims

1. A method for the production of structured contacts arranged on one side in a layered arrangement for a photovoltaic component, which has at least one substrate (1), a first doped semiconductor layer of one conductivity type (2), and a second doped semiconductor layer of an opposite conductivity type (5), having at least the following method steps:
- application of a masking layer arrangement (3, 4) with at least one masking layer (3) onto the first doped semiconductor layer arranged on the substrate,
- generation of structures for contact apertures in the first doped semiconductor layer in the masking layer arrangement,
- subsequent etching of the structured masking layer arrangement (3, 4) for the generation of contact apertures in the first doped semiconductor layer (2),
- thereafter a full-surface conformal application of the second doped semiconductor layer of an opposite conductivity type (5), and
- followed by an at least partial removal of the remaining masking layer arrangement (3, 4) and the second doped semiconductor layer (5) so as to expose the structured first doped semiconductor layer (2), and
- a final introduction of contact material into the contact apertures and onto the exposed first doped semiconductor layer, wherein
a doped silicon-rich layer, which is nanocrystalline or amorphous, is used as the first doped semiconductor layer of one conductivity type (2), and as the second doped semiconductor layer of an opposite conductivity type (5),
**characterised in that**,
- a single layer is used for the at least one masking layer (3), wherein the single layer is formed from SiOₓN_{y} and has a low gradient in silicon content in the vicinity of the substrate (1) and increasing in the direction of the second doped semiconductor layer (5) to be applied,
- the etching of the structured masking layer arrangement with an etching of the structured single layer (3) is executed in at least one etching step in a silicon-etching solution, at least for purposes of removing the first doped silicon-rich layer (2) in the structures for contact apertures, and at the same time the remaining exposed surface of the single layer (3) is roughened,
- the at least partial removal of the remaining single layer (3) and of the second doped silicon-rich layer (5) arranged on its rough surface for purposes of exposing the structured first silicon-rich layer (2) is executed by means of a lift-off process in an HF-containing solution.

2. A method for the production of structured contacts arranged on one side in a layer arrangement for a photovoltaic component, which has at least one substrate (1), a first doped semiconductor layer of one conductivity type (2), and a second doped semiconductor layer of an opposite conductivity type (5), having at least the following method steps:
- application of a masking layer arrangement (3, 4) with at least one masking layer (3) onto the first doped semiconductor layer arranged on the substrate,
- generation of structures for contact apertures in the first doped semiconductor layer in the masking layer arrangement,
- subsequent etching of the structured masking layer arrangement (3, 4) for the generation of contact apertures in the first doped semiconductor layer (2),
- thereafter a full-surface conformal application of the second doped semiconductor layer of an opposite conductivity type (5), and
- followed by an at least partial removal of the remaining masking layer arrangement (3, 4) and the second doped semiconductor layer (5) so as to expose the structured first doped semiconductor layer (2), and
- a final introduction of contact material into the contact apertures and onto the exposed first doped semiconductor layer, wherein
a doped silicon-rich layer, which is nanocrystalline or amorphous, is used as the first doped semiconductor layer of one conductivity type (2), and as the second doped semiconductor layer of an opposite conductivity type (5), **characterised in that**,
- for the masking layer arrangement (3, 4), two masking layers (3, 4) with materials of different selective etchability are applied, wherein
the masking layer (3) arranged closest to the substrate is a silicon-poor layer with greater etchability in an HF-containing etching agent than the second masking layer (4), which is designed to be silicon-rich and can be etched in an Si-etching agent,
- the etching of the structured masking layer arrangement (3, 4) is executed in at least one etching step in a silicon-etching solution at least for purposes of removing the first doped silicon-rich layer (2) in the structures for the contact apertures, and for purposes of removing the silicon-rich masking layer (4) in the unstructured regions of the masking layer arrangement (3, 4), and wherein at the same time the remaining exposed surface of the silicon-poor masking layer (3) is roughened,
- the at least partial removal of the remaining silicon-poor masking layer (3) and the second doped silicon-rich layer (5) arranged on its rough surface is executed for purposes of exposing the structured first silicon-rich layer (2) by means of a lift-off process in an HF-containing solution.

3. The method in accordance with claim 1,
**characterised in that**,
before the etching of the structured masking layer (3), a further etching step is carried out in an HF-containing solution.

4. The method in accordance with claim 2,
**characterised in that**,
before the etching of the structured masking layer arrangement (3, 4), a further etching step is carried out in an HF-containing solution.

5. The method in accordance with claim 2,
**characterised in that**,
an SiOₓN_{y} layer is used as the silicon-poor masking layer (3).

6. The method in accordance with claim 5,
**characterised in that**,
the SiOₓN_{y} layer (3) is constructed as a layer sequence, wherein the layer concluding the layer sequence is the richest in silicon.

7. The method in accordance with claim 5,
**characterised in that**,
the SiOₓN_{y} layer (3) has a gradient in silicon content, which increases towards the surface of the said layer.

8. The method in accordance with claim 5,
**characterised in that**,
an SiO₂ layer is used as the SiOₓN_{y} layer (3).

9. The method in accordance with claim 2,
**characterised in that**,
an amorphous or nanocrystalline Si-layer is used as the second silicon-rich masking layer (4).

10. The method in accordance with claim 9,
**characterised in that**,
a p-doped amorphous Si-layer is used as the amorphous Si-layer (4).

11. The method in accordance with at least one of the preceding claims 2 to 10,
**characterised in that**,
a further SiOₓN_{y} layer is applied onto the masking layer arrangement (3, 4) before the step of generating structures for the contact apertures, and a further wet-chemical etching step is executed in a silicon-etching solution before the etching steps.

12. The method in accordance with claim 1 or 2,
**characterised in that**,
the generation of structures for contact apertures takes place by means of laser ablation.

13. The method in accordance with claim 1 or 2,
**characterised in that**,
the generation of structures for contact apertures takes place by means of wet-chemical etching.

14. The method in accordance with claim 1 or 2,
**characterised in that**,
before a deposition of the first doped silicon-rich layer (2) onto the substrate, and/or before a deposition of the second doped silicon-rich layer (5), an intrinsic hydrogen-containing amorphous silicon layer is applied as a passivation layer in each case.

## Revendications

1. Procédé de fabrication de contacts structurés unilatéralement disposés dans un système de couches pour un composant photovoltaïque, qui comporte au moins un substrat (1), une première couche semi-conductrice dopée d'un type de conductibilité (2) et une deuxième couche semi-conductrice dopée avec un type de conductibilité opposé (5), comportant au moins les étapes de procédé suivante s :
- application d'un système de couches de masquage (3, 4) avec au moins une couche de masquage (3) sur la première couche semi-conductrice dopée disposée sur le substrat,
- production de structures pour des ouvertures de contact dans la première couche semi-conductrice dopée dans le système de couches de masquage,
- gravure ultérieur du système de couches de masquage structuré (3, 4) pour la production d'ouvertures de contact dans la première couche semi-conductrice dopée (2),
- ensuite, application conforme sur toute la surface de la deuxième couche semi-conductrice dopée de type de conductibilité opposé (5) et
- successivement au moins un enlèvement partiel du système de couches de masquage encore subsistant (3, 4) et de la deuxième couche semi-conductrice dopée (5) pour libérer la première couche semi-conductrice dopée structurée (2), et
- insertion successive du matériau de contact dans les ouvertures de contact et sur la première couche semi-conductrice dopée libérée,
sachant qu'en tant que première couche semi-conductrice dopée d'un type de conductibilité (2) et en tant que deuxième couche semi-conductrice dopée avec un type de conductibilité opposé (5), on utilise une couche riche en silicium dopée, qui est nanocristalline ou amorphe, **caractérisé en ce que**
- au moins une couche de masquage (3), on utilise une couche individuelle, sachant que la couche individuelle est formée de SiOₓN_{y} et comporte un gradient en teneur de silicium allant de faible à proximité du substrat (1) et augmentant en direction de la deuxième couche semi-conductrice dopée à appliquer (5),
- la gravure du système de couches de masquage structuré est effectuée avec un gravure de la couche individuelle structurée (3) dans au moins une étape de gravure dans une solution attaquant le silicium au moins pour enlever la première couche riche en silicium dopée (2) dans les structures pour les ouvertures de contact et la surface libéré restante de la couche individuelle (3) est simultanément grattée,
- l'enlèvement au moins partiel de la couche individuelle encore restante (3) et de la deuxième couche riche en silicium dopée (5) disposée sur sa surface grattée est exécuté pour libérer la première couche riche en silicium structurée (2) au moyen du processus de décollement dans une solution à teneur en HF.

2. Procédé de fabrication de contacts structurés unilatéralement disposés dans un système de couches pour un composant photovoltaïque, qui comporte au moins un substrat (1), une première couche semi-conductrice dopée d'un type de conductibilité (2) et une deuxième couche semi-conductrice dopée avec un type de conductibilité opposé (5), comportant au moins les étapes de procédé suivantes :
- application d'un système de couches de masquage (3, 4) avec au moins une couche de masquage (3) sur la première couche semi-conductrice dopée disposée sur le substrat,
- production de structures pour des ouvertures de contact dans la première couche semi-conductrice dopée dans le système de couches de masquage,
- gravure consécutive du système de couches de masquage structuré (3, 4) pour la production d'ouvertures de contact dans la première couche semi-conductrice dopée (2),
- ensuite, application conforme sur toute la surface de la deuxième couche semi-conductrice dopée de type de conductibilité opposé (5) et
- successivement au moins un enlèvement partiel du système de couches de masquage encore subsistant (3, 4) et de la deuxième couche semi-conductrice dopée (5) pour libérer la première couche semi-conductrice dopée structurée (2), et
- insertion successive du matériau de contact dans les ouvertures de contact et sur la première couche semi-conductrice dopée libérée,
sachant qu'en tant que première couche semi-conductrice dopée d'un type de conductibilité (2) et en tant que deuxième couche semi-conductrice dopée avec un type de conductibilité opposé (5), on utilise une couche riche en silicium dopée, qui est nanocristalline ou amorphe, **caractérisé en ce que**
- pour le système de couches de masquage (3, 4) deux couches de masquage (3, 4) sont appliquées avec des matériaux d'une corrosivité sélective différente, sachant que la couche de masquage (3) suivante disposée sur le substrat est une couche pauvre en silicium avec une corrosivité plus grande en agent de gravure à teneur en HF que la deuxième couche de masquage (4), qui est formée riche en silicium et peut être gravée dans un agent de gravure attaquant le Si,
- la gravure du système de couches de masquage structuré (3, 4) dans au moins une étape de gravure dans une solution attaquant le silicium est exécutée au moins pour enlever la première couche riche en silicium dopée (2) dans les structures pour les ouvertures de contact et pour enlever la couche de masquage (4) riche en Si dans les zones non structurées du système de couches de masquage (3, 4) et sachant que la surface libérée restant de la couche de masquage pauvre en Si (3) est simultanément grattée,
- l'enlèvement au moins partiel de la couche de masquage (3) pauvre en silicium encore restante et de la deuxième couche riche en silicium (5) dopée est exécuté pour libérer la première couche riche en silicium structurée (2) au moyen du processus de décollement dans une solution à teneur en HF.

3. Procédé selon la revendication 1, **caractérisé en ce qu'**avant la gravure de la couche de masquage structurée (3) une autre étape de gravure est exécutée dans une solution à teneur en HF.

4. Procédé selon la revendication 2,
**caractérisé en ce qu'**
une autre étape de gravure est exécutée dans une solution à teneur en HF avant la gravure du système de couche de masquage structuré (3, 4).

5. Procédé selon la revendication 2,
**caractérisé en ce qu'**
une couche SiOₓN_{y} est utilisée comme couche de masquage pauvre en silicium (3).

6. Procédé selon la revendication 5,
**caractérisé en ce que**
la couche SiOₓN_{y} (3) est structurée sous la forme d'une succession de couches, sachant que la couche clôturant la succession de couches est la plus riche en silicium.

7. Procédé selon la revendication 5,
**caractérisé en ce que**
la couche SiOₓN_{y} (3) comporte un gradient dans la teneur en silicium, qui augmente vers la surface de cette couche.

8. Procédé selon la revendication 5,
**caractérisé en ce qu'**
une couche SiO₂ est utilisée en tant que couche SiOₓN_{y} (3).

9. Procédé selon la revendication 2,
**caractérisé en ce qu'**
une couche Si amorphe ou nanocristalline est utilisée en tant que deuxième couche de masquage riche en silicium (4).

10. Procédé selon la revendication 9,
**caractérisé en ce qu'**
une couche Si amorphe à dopage p est utilisée comme couche Si amorphe (4).

11. Procédé selon l'une quelconque des revendications précédentes 2 à 10,
**caractérisé en ce qu'**
une autre couche SiOₓN_{y} est appliquée sur le système de couches de masquage (3, 4) avant l'étape de production de structures pour les ouvertures de contact et une autre étape de gravure chimique humide est exécutée, avant les étapes de gravure, dans une solution attaquant le silicium.

12. Procédé selon la revendication 1 ou 2, **caractérisé en ce que**
la production de structures pour des ouvertures de contact a lieu au moyen de l'ablation au laser.

13. Procédé selon la revendication 1 ou 2, **caractérisé en ce que**
la production de structures pour des ouvertures de contact a lieu au moyen de gravure chimique humide.

14. Procédé selon la revendication 1 ou 2, **caractérisé en ce qu'**avant une séparation de la première couche riche en silicium dopée (2) sur le substrat et/ou avant une séparation de la deuxième couche riche en silicium dopée (5), une couche de silicium amorphe hydrogénée intrinsèque est respectivement appliquée en tant que couche de passivation.
